# EUROPEAN PATENT APPLICATION

(11) **EP 3 179 391 A1**
(43) Date of publication of application: **14.06.2017**
(21) Application number: 16465501.1
(22) Date of filing: 08.01.2016
(51) Int. Cl.: G06F 17/50, H05K 5/02, H05K 5/00

(54) **METHOD FOR CONSTRUCTING A TRANSITION PORTION OF A COMPONENT**

(71) Applicant: Continental Automotive GmbH, 30165 Hannover (DE)
(72) Inventor: Vornicu, Vlad, 705200 Pascani (RO); Crismaru, Ionut, 700080 Iasi (RO)

(57) **Abstract**

The invention relates to a method for constructing a transition portion (16) of a component (10) having the transition portion (16), at least one wall portion (12) and at least one protrusion (14) protruding, in a direction of protrusion, from the wall portion (12) and passing into the wall portion (12) via the transition portion (16) wherein the method comprises the steps of
- along the direction of protrusion, defining a first number of first segments (30a-e) of the protrusion (14), wherein each first segment (30a-e) extends from a first starting point (1-5) to a first end point respectively;
- along a second direction extending perpendicularly to the direction of protrusion, defining a second number of second segments (32a-e) of the wall portion (12), wherein each second segment (32a-e) extends from a second starting point to a second end point (1'-5') respectively, and wherein the second number equals the first number; and
- connecting each first starting point (1-5) with a corresponding one of the second end points (1'-5') by respective construction lines (34a-e) intersecting each other at respective intersection points (36a-d) such that respective portions (38) of the construction lines (34a-e) adjoin one other at the respective intersection points (36a-d), the respective portions (38) of the construction lines (34a-e) forming an outer contour (22) of the transition portion (16).

## Description

The invention relates to a method for constructing a transition portion of a component, in particular of a plastic component for a vehicle.

Plastic components having transition portions, wall portions and protrusions are known, wherein the respective protrusion protrudes from the respective wall portion in a direction of protrusion. Moreover, the wall portion passes into the protrusion via the transition portion or vice versa. Said plastic component is made of a plastic material, wherein the wall portion, the transition portion and the protrusion are made in one piece. Conventionally, the transition portion is also referred to as a transition radius since the transition portion has the form or an outer contour of a radius. In conventional transition portions particularly high stresses may occur.

It is therefore an object of the present invention to provide a method by means of which excessively high stresses in transition portions of components can be avoided.

This object is solved by a method having the features of claim 1. Advantageous embodiments with expedient developments of the invention are indicated in the dependent claims.

A first aspect of the present invention relates to a method for constructing a transition portion of a component. Said component comprises the transition portion, at least one wall portion and at least one protrusion which protrudes from the at least one wall portion in a direction of protrusion. Moreover, the at least one protrusion passes into the at least one wall portion via the transition portion.

The method according to the present invention comprises a first step in which, along said direction of protrusion, a first number of first segments of the at least one protrusion are defined, the segments having essentially equal lengths with respect to the direction of protrusion. Each first segment extends from a first starting point to a first end point with respect to the direction of protrusion respectively. The first segments adjoin one another consecutively at the respective first end points. In other words, the respective end point of the respective first segment is the respective starting point of a following one of the first segments.

The method further comprises a second step in which, along a second direction extending essentially perpendicularly to the direction of protrusion, a second number of second segments of the at least one wall portion are defined, the second segments having essentially equal lengths with respect to the second direction. Each second segment extends from a second starting point to a second end point with respect to the second direction respectively, wherein the second segments adjoin one another consecutively at the respective second end points. This means the respective end point of the respective second segment is the respective starting point of a following one of the second segments. Moreover, the second number equals the first number.

The method according to the present invention further comprises a third step in which each first starting point is connected with a corresponding one of the second end points by respective construction lines intersecting each other at respective intersection points such that respective portions of (different ones of) the construction lines adjoin one another at the respective intersection points, the respective portions of the construction lines forming an outer contour of the transition portion.

By constructing or designing the transition portion by means of the method according to the present invention, stresses occurring in the transition portion may be kept particularly low. In particular, von Mises stress (for bending calculation) as well as normal stress (for tensile calculation) may be kept particularly low in the transition portion so that the component can be designed as a particularly robust part. In other words, by constructing the transition portion, in particular in the form of a transition radius, by means of the method according to the present invention, strain resistance may be improved and stress concentrators may be minimized. By means of the method according to the present invention, the resistance for tensile and/or bending loads may be improved in comparison to conventional components.

In a preferred embodiment of the present invention, the method comprises a step in which, along a third direction opposite to the direction of protrusion, the first starting points are serially numbered in ascending order by using positive whole numbers starting with a first positive whole number. Moreover, along a fourth direction extending essentially perpendicularly to the third direction and away from the protrusion, the second end points are serially numbered in ascending order by using positive whole numbers starting with said first positive whole number. Furthermore, each first starting point is connected with a corresponding one of the second end points by said construction lines in such a way that the first starting points and the second end points having the same positive whole numbers are connected with each other by one of the construction lines respectively. This means, for example, the first starting point having the positive whole number 1 is connected with the second end point having the positive whole number 1. Moreover, the first starting point having the positive whole number 2 is connected with the second end point having the positive whole number 2 by a construction line. This rule or algorithm of connecting the respective first starting points with the respective second end points by means of respective construction lines applies to all first starting points and second end points. Thereby, stresses occurring in the transition portion can be kept particularly low.

The higher the first and second numbers are, the more precise the transition portion, in particular its profile, will be. Moreover, stresses in the transition portion can be reduced by increasing the first and second numbers.

Preferably, the first and second numbers are at least 5, in particular at least 10, preferably at least 20, so that stresses in the transition portion can be kept particularly low and the component can be manufactured in a cost-effective way.

In a further particularly advantageous embodiment of the invention, the at least one protrusion is a dome having at least one receptacle. Preferably, at least one screw thread, in particular a female thread, is arranged in the receptacle.

In a further advantageous embodiment of the invention, the at least one protrusion is a latching element, by means of which the component can be connected to a further component, in particular of a vehicle, by, for example, form-fit.

In a further advantageous embodiment of the invention, the at least one protrusion is a hook.

Preferably, the component is part of an electronic control unit (ECU), in particular of an electronic control unit for a vehicle.

In a further advantageous embodiment of the invention, the component is made of a plastic material.

In a further advantageous embodiment of the invention, the at least one wall portion, the transition portion and the at least one protrusion are made in one piece. In particular, the at least one wall portion, the transition portion and the at least one protrusion may be made in one piece of said plastic material.

A second aspect of the present invention relates to a component having a transition portion, at least one wall portion and at least one protrusion protruding, in a direction of protrusion, from the at least one wall portion and passing into the at least one wall portion via the transition portion, wherein the component is designed by means of a method according to an embodiment of the present invention.

Advantageous embodiments and advantages of the method according to the present invention are to be regarded as advantageous embodiments and advantages of the component according to the present invention and vice versa.

In a particularly advantageous embodiment of the invention, the at least one protrusion is a dome having at least one receptacle. Preferably, at least one screw thread, in particular a female thread, is arranged in the receptacle.

In a further advantageous embodiment of the invention, the at least one protrusion is a latching element, by means of which the component can be connected to a further component, in particular of a vehicle, by, for example, form-fit.

In a further advantageous embodiment of the invention, the at least one protrusion is a hook.

Preferably, the component is part of an electronic control unit (ECU), in particular of an electronic control unit for a vehicle.

In a further advantageous embodiment of the invention, the component is a plastic component.

Further advantages, features and details of the invention derive from the following description of preferred embodiments as well as from the drawings. The features and feature combinations previously mentioned in the description as well as the features and feature combinations mentioned in the following description of the figures and/or illustrated in the figures alone can be employed not only in the respectively indicated combination but also in other combinations or taken alone without leaving the scope of the invention.

The drawings illustrate in
- Fig. 1: a schematic and perspective sectional view of a plastic component for a vehicle, the plastic component having at least one wall portion, at least one protrusion protruding from the wall portion, and at least one transition portion via which the wall portion passes into the protrusion according to an embodiment;
- Fig. 2: part of a schematic side view of the plastic component for illustrating a method for constructing the transition portion according to an embodiment;
- Fig. 3: a diagram for illustrating said method for constructing the transition portion;
- Fig. 4: a further diagram for illustrating said method;
- Fig. 5: a further diagram for illustrating a second embodiment of the method;
- Fig. 6: a further diagram for illustrating a third embodiment of the method; and
- Figs. 7a-d: a schematic perspective view of different embodiments of the plastic components respectively.

In the figures the same elements or elements having the same functions are indicated by the same reference signs.

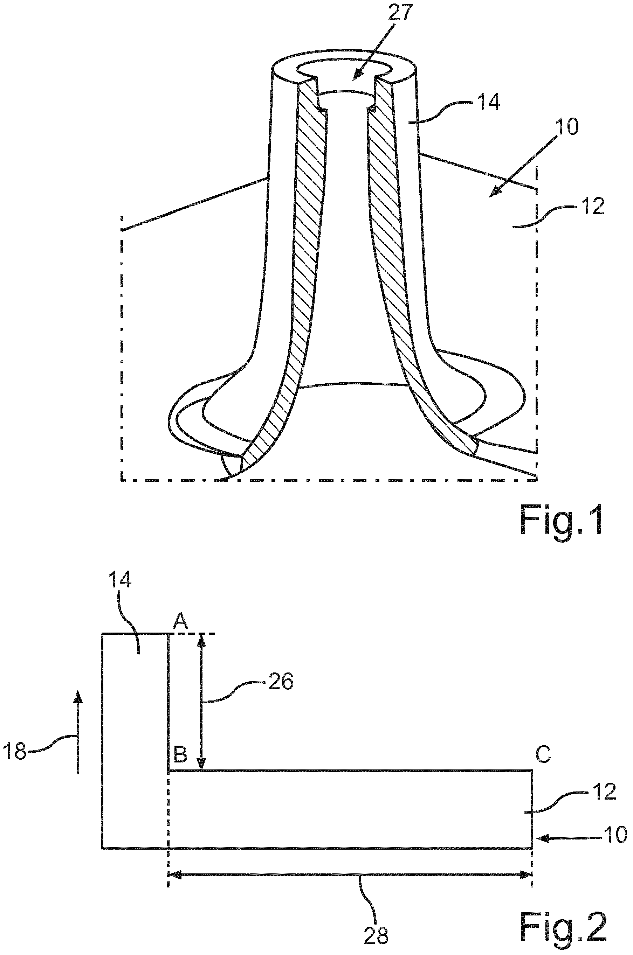

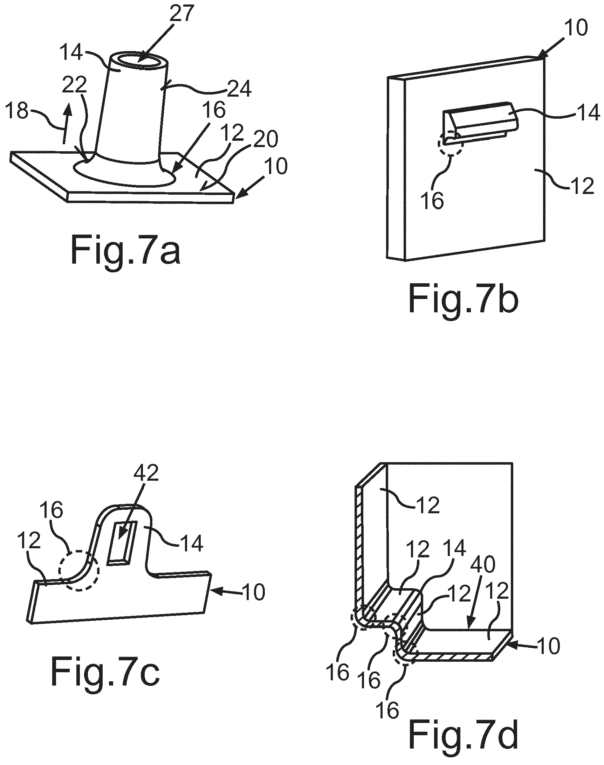

Figs. 1 and 7a illustrate a first embodiment of a component 10 for a vehicle (not illustrated), in particular a motor vehicle. For example, the motor vehicle comprises an internal combustion engine (not illustrated) and an electronic control unit (ECU) for operating, in particular controlling, said internal combustion engine. For example, the component 10 is part of said electronic control unit.

In the illustrated embodiment, the component 10 is a plastic component. The plastic component 10 is made of a plastic material and comprises at least one wall portion 12, at least one protrusion 14 and at least one transition portion 16. The protrusion 14 protrudes from the wall portion 12 in a direction of protrusion illustrated by an arrow 18. For example, the wall portion 12 has a surface 20 extending in a first plane, wherein said direction of protrusion extends perpendicularly to the first plane. The protrusion 14 passes into the wall portion 12 via the transition portion 16 which is curved. In other words, the transition portion 16 has a curved outer contour 22 via which an outer contour 24 of the protrusion 14 passes into the surface 20. Since the outer contour 22 is curved, the transition portion 16 is also referred to as a transition radius.

In the first embodiment, the protrusion 14 is a dome having a receptacle 27. For example, the dome is a screw dome, wherein a screw thread (not illustrated), in particular a female thread, can be arranged in the receptacle 27. Thus, the plastic component 10 can be screwed to a further component (not illustrated) of the vehicle by means of said screw thread and a screw (not illustrated) screwed to the screw thread arranged in the receptacle 27.

The wall portion 12, the protrusion 14, and the transition portion 16 are made in one piece. Hence, the wall portion 12, the protrusion 14 and the transition portion 16 are made of said plastic material.

With respect to Figs. 2 to 4, a first embodiment of a method for constructing the transition portion 16 is illustrated. In Fig. 2, the plastic component 10 is schematically illustrated without the transition portion 16. Thus, the wall portion 12 and the protrusion 14 can be seen in Fig. 2. In Fig. 2, an arrow 26 illustrates that, with respect to the direction of protrusion, the protrusion 14 extends from a point A to a point B. Moreover, as illustrated by an arrow 28, the wall portion 12 extends from point B to a point C in a second direction which extends essentially perpendicularly to the direction of protrusion. Said second direction is illustrated by the arrow 28. As can be seen from Fig. 2, the protrusion 14 ends at the point B, wherein the wall portion 12 starts at the point B.

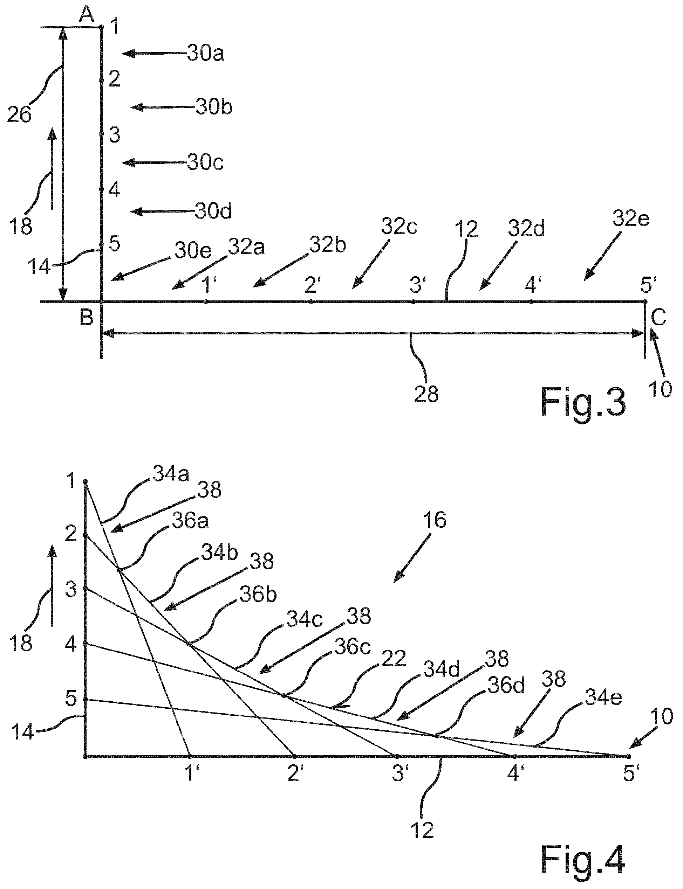

In a first step of said method, a first number n of first segments 30a-e (Fig. 3) of the protrusion 14 is defined along the direction of protrusion. The first segments 30a-e have equal lengths with respect to the direction of protrusion. Moreover, each first segment 30a-e extends from a first starting point 1-5 to a first end point respectively, wherein the first segments 30a-e adjoin one another consecutively at the respective first end points. This means the starting point 1 of the segment 30a is the point A, wherein the end point of the segment 30a is the starting point 2 of the segment 30b. The end point of the segment 30b is the starting point 3 of the segment 30c, wherein the end point of the segment 30c is the starting point 4 of the segment 30d. Moreover, the end point of the segment 30d is the starting point 5 of the segment 30e, wherein the end point of the segment 30e is point B.

In a second step of the method, a second number of second segments 32a-e (Fig. 3) of the wall portion 12 is defined along said second direction extending essentially perpendicularly to the direction of protrusion. The second segments 32a-e have equal lengths with respect to the second direction, wherein each second segment 32a-e extends from a second starting point to a second end point 1'-5' respectively. The second segments 32a-e adjoin one another consecutively at the respective second end points 1'-5', wherein the second number equals the first number. As can be seen from Fig. 3, point B, which is the end point of the first segment 30e, is the starting point of the second segment 32a. The end point 1' of the second segment 32a is the starting point of the second segment 32b. The end point 2' of the second segment 32b is the starting point of the second segment 32c, wherein the end point 3' of the segment 32c is the starting point of the segment 32d. Moreover, the end point 4' of the segment 32d is the starting point of the segment 32e, wherein the end point 5' of the segment 32e is the point C.

In a third step of said method, each first starting point 1-5 is connected with a corresponding one of the second end points 1' -5' by respective construction lines 34a-e (Fig. 4) intersecting each other at respective intersection points 36a-d such that respective portions 38 of (different ones of) the construction lines 34a-e adjoin one another at the respective intersection points 36a-d, wherein the respective portions 38 of the (different ones of the) construction lines 34a-e form the outer contour 22 of the transition portion 16. Fig. 4 illustrates a first embodiment of the method, wherein in the first embodiment the first and second numbers are five.

As can be seen from Figs. 3 and 4, the first starting points 1-5 are serially numbered in ascending order along a third direction opposite to the direction of protrusion by using positive whole numbers starting with a first positive whole number, wherein said first positive whole number is 1. Moreover, the second end points 1'-5' are serially numbered in ascending order along a fourth direction extending perpendicularly to the third direction and away from the protrusion by using positive whole numbers starting with the first positive whole number 1. Moreover, each first starting point 1-5 is connected with the corresponding one of the second end points 1'-5' in such a way that the first starting points 1-5 and the second end points 1'-5' having the same positive whole numbers (1-5) are connected with each other by one of the construction lines 34a-e respectively. This means the starting point 1 is connected with the end point 1' by the construction line 34a. The starting point 2 is connected with the end point 2' by the construction line 34b. The starting point 3 is connected with the end point 3' by the construction line 34c. The starting point 4 is connected with the end point 4' by the construction line 34d. Finally, the starting point 5 is connected with the end point 5' by the construction line 34e.

Thus, a first one of said portions 38 extends from the starting point 1 to the intersection point 36a, a second one of the portions 38 extends from intersection point 36a to intersection point 36b, a third one of said portions 38 extends from intersection point 36b to intersection point 36c, a fourth one of said portions 38 extends from intersection point 36c to intersection point 36d and a fifth one of said portions 38 extends from intersection point 36d to end point 5' . By constructing or designing the transition portion 16 by means of said method, stresses occurring in the transition portion 16 can be kept particularly low, in particular in tensile and bending loading cases.

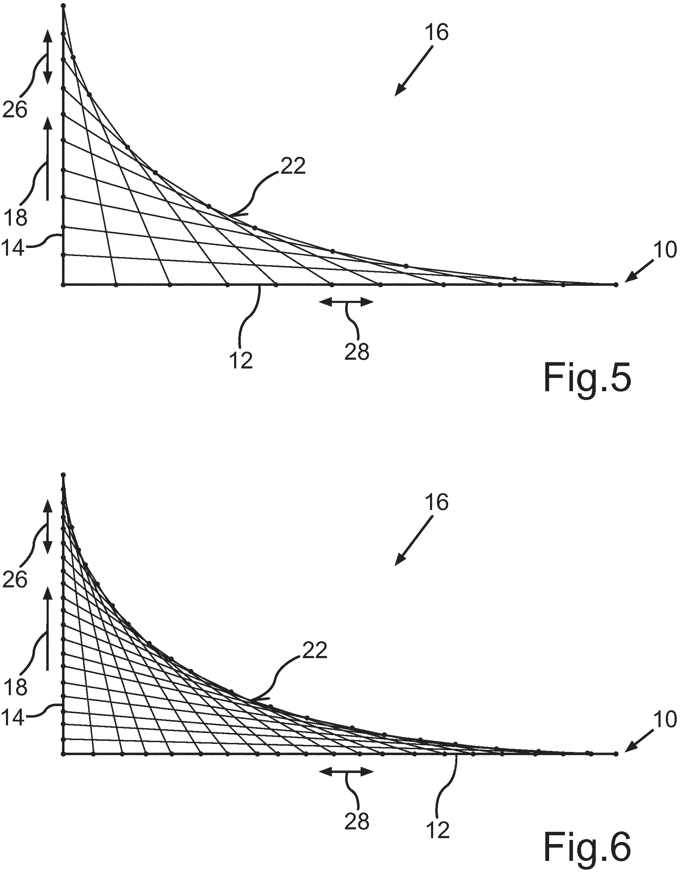

Fig. 5 illustrates a second embodiment of the method, wherein in said second embodiment the first and second numbers are 10. Thus, the first starting points are numbered consecutively from 1 to 10, wherein the second end points are consecutively numbered from 1 to 10.

Fig. 6 illustrates a third embodiment of the method, wherein in said third embodiment the first and second numbers are 20. Thus, the first starting points are serially numbered from 1 to 20, wherein the second end points are serially numbered from 1 to 20. Since the first number n equals the second number, the number of construction lines equals the first and the second numbers. Moreover, the number of intersection points is indicated by x, wherein x=n-1. Moreover, the first and second numbers are indicated by n. By designing the transition portion 16 by means of said method, stresses or loads occurring in the transition portion 16 may be drastically reduced in comparison with conventional plastic components.

Figs. 7a-d illustrate different embodiments of the plastic component 10.

As already mentioned above, Fig. 7a illustrates a first embodiment of the plastic component 10, wherein in the first embodiment, the protrusion 14 is configured as a dome having a receptacle 27.

Fig. 7b illustrates a second embodiment of the plastic component 10. In said second embodiment, the protrusion 14 is configured as a hook by means of which the plastic component 10 can be connected to, for example, a further component (not illustrated) of the vehicle, in particular of the electronic control unit.

Moreover, Fig. 7c illustrates a third embodiment of the plastic component 10, wherein in the third embodiment the protrusion 14 is configured as a snapper or a latching element by means of which the plastic component 10 can be connected with a further component (not illustrated) by means of, for example, form-fit. In particular, in the illustrated embodiment, the protrusion 14 has a through opening 42, wherein, for example, a latching element (not illustrated) of the further component can engage the through opening 42, thereby connecting the further component to the plastic component 10 by means of, for example, form-fit.

Moreover, Fig. 7d illustrates a fourth embodiment of the plastic component 10. In the fourth embodiment, the plastic component 10 is part of a housing, wherein said part is a bottom 40 of said housing. In said housing, the protrusion 14 protrudes, for example, into the housing.

By designing the protrusion 14 using said method, a better resistance may be provided in order to prevent damage during transportation or operation or functionality. In particular, stress concentration values in the transition portion 16 may be decreased relative to conventional plastic components.

### List of reference signs

- 1-5: starting point
- 1'-5': end point
- 10: component
- 12: wall portion
- 14: protrusion
- 16: transition portion
- 18: arrow
- 20: surface
- 22: outer contour
- 24: outer contour
- 26: arrow
- 27: receptacle
- 28: arrow
- 30a-e: first segment
- 32a-e: second segment
- 34a-e: construction line
- 36a-d: intersection point
- 38: portion
- 40: bottom
- 42: through opening
- A: point
- B: point
- C: point

## Claims

1. A method for constructing a transition portion (16) of a component (10) having the transition portion (16), at least one wall portion (12) and at least one protrusion (14) protruding, in a direction of protrusion, from the at least one wall portion (12) and passing into the at least one wall portion (12) via the transition portion (16), wherein the method comprises the steps of
- along the direction of protrusion, defining a first number of first segments (30a-e) of the at least one protrusion (14), the first segments (30a-e) having essentially equal lengths with respect to the direction of protrusion, wherein each first segment (30a-e) extends from a first starting point (1-5) to a first end point respectively, and wherein the first segments (30a-e) adjoin one another consecutively at the respective first end points;
- along a second direction extending essentially perpendicularly to the direction of protrusion, defining a second number of second segments (32a-e) of the at least one wall portion (12), the second segments (32a-e) having essentially equal lengths with respect to the second direction, wherein each second segment (32a-e) extends from a second starting point to a second end point (1'-5') respectively, wherein the second segments (32a-e) adjoin one another consecutively at the respective second end points (1'-5'), and wherein the second number equals the first number; and
- connecting each first starting point (1-5) with a corresponding one of the second end points (1'-5') by respective construction lines (34a-e) intersecting each other at respective intersection points (36a-d) such that respective portions (38) of the construction lines (34a-e) adjoin one other at the respective intersection points (36a-d), the respective portions (38) of the construction lines (34a-e) forming an outer contour (22) of the transition portion (16).

2. The method according to claim 1, wherein the method comprises the steps of
- along a third direction opposite to the direction of protrusion, serially numbering the first starting points (1-5) in ascending order by using positive whole numbers starting with a first positive whole number;
- along a fourth direction extending essentially perpendicularly to the third direction and away from the protrusion, serially numbering the second end points (1'-5') in ascending order by using positive whole numbers starting with said first positive whole number; and
- connecting each first starting point (1-5) with the corresponding one of the second end points (1'-5') by said construction lines (34a-e) in such a way that the first starting points (1-5) and the second end points (1'-5') having the same positive whole numbers are connected with each other by one of the construction lines (34a-e) respectively.

3. The method according to claim 1 or 2, wherein the first and second numbers are at least 5, in particular 10, preferably 20.

4. The method according to any one of the preceding claims, wherein the at least one protrusion (14) is a dome having at least one receptacle (27).

5. The method according to claim 4, wherein at least one screw thread is arranged in the receptacle (27).

6. The method according to any one of the preceding claims, wherein the at least one protrusion (14) is a latching element.

7. The method according to any one of the preceding claims, wherein the at least one protrusion (14) is a hook.

8. The method according to any one of the preceding claims, wherein the component (10) is part of an electronic control unit, in particular of an electronic control unit for a vehicle.

9. The method according to any one of the preceding claims, wherein the component (10) is made of a plastic material.

10. The method according to any one of the preceding claims, wherein the at least one wall portion (12), the transition portion (16) and the at least one protrusion (14) are made in one piece.

11. A component (10) having a transition portion (16), at least one wall portion (12) and at least one protrusion (14) protruding, in a direction of protrusion, from the at least one wall portion (12) and passing into the at least one wall portion (12) via the transition portion (16), wherein the component (10) is designed by means of a method according to any one of the preceding claims.

12. The component (10) according to claim 11, wherein the at least one protrusion (14) is a dome having at least one receptacle (27).

13. The component (10) according to claim 11 or 12, wherein the at least one protrusion (14) is a latching element.

14. The component (10) according to any one of claims 11 to 13, wherein the at least one protrusion (14) is a hook.

15. The component (10) according to any one of claims 11 to 14, wherein the component (10) is a plastic component.
